# EUROPEAN PATENT APPLICATION

(11) **EP 0 867 538 A1**
(43) Date of publication of application: **30.09.1998**
(21) Application number: 98301869.8
(22) Date of filing: 12.03.1998
(51) Int. Cl.: C30B 25/12, C30B 31/14, C23C 16/44

(54) **Heating apparatus**

(30) Priority: 24.03.1997 JP 69492/97; 26.02.1998 JP 45636/98
(71) Applicant: Shin-Etsu Handotai Co., Ltd, Chiyoda-ku Tokyo (JP)
(72) Inventor: Habuka, Hitoshi, Maebashi-shi, Gunma-ken (JP); Otsuka, Toru, Annake-shi, Gunma-ken (JP)
(74) Representative: Curtis, Philip Anthony

(57) **Abstract**

A heating apparatus capable of heating a semiconductor single crystal substrate to a desired temperature in a short time, and suppressing the generation of defects such as slip dislocation possibly encountered in the semiconductor single crystal substrate, a semiconductor crystal thin film manufactured based on the semiconductor single crystal substrate and so on. The heating apparatus is extremely useful in a process associated with the heating of future semiconductor single crystal substrates expected to have increasingly larger diameters. Radiant light emitted from a radiant heat source (16) arranged outside a transparent vessel (10) is used to heat a semiconductor single crystal substrate (12) mounted in a heated region of the transparent vessel. A substrate support (11) positioned between the radiant heat source and the semiconductor single crystal substrate for supporting the semiconductor single crystal substrate is made of a material which transmits the radiant light emitted from the radiant heat source and has a higher heat conductivity than graphite.

## Description

The present invention relates to a heating apparatus for heating a semiconductor single crystal substrate using radiant light emitted from a radiant heat source.

As one of techniques for heating a semiconductor single crystal, a vapor-phase growth apparatus as described in, for example, Laid-Open Japanese Patent Application No. 50-8473 is used for vapor-phase growing a silicon single crystal thin film on a silicon single crystal substrate at temperatures ranging from 1000 °C to 1200 °C. In this vapor-phase growth apparatus, a silicon single crystal substrate is mounted on a substrate support made of graphite positioned in a reactor vessel with its entire back surface being in contact with the substrate support. Since the substrate support made of graphite has a large heat capacity, it can efficiently absorb energy radiated from infrared lamps.

Next, as energy at a specific wavelength is radiated from infrared lamps, the substrate support absorbs the energy at the specific wavelength to heat itself. As a result, the silicon single crystal substrate mounted on the substrate support is heated at its main surface by the infrared lamps and concurrently at its back surface by the substrate support, so that a thermal gradient within the silicon single crystal substrate becomes smaller to suppress the generation of slip dislocation. The slip dislocation is caused by a stress existing during a heat treatment, which may be a thermal stress or a bending stress. Therefore, by uniformly heating a silicon single crystal substrate to reduce the thermal gradient, the slip dislocation caused by a thermal stress can be suppressed.

In recent years, the diameters of silicon single crystal substrates are being increased with the advance of the electronic industrial technologies. It is expected that in the near future, silicon semiconductor single crystal substrates having a diameter of 300 mm will be put into practical use, and subsequently the diameter will be increased to 400 mm.

As silicon single crystal substrates having larger diameters are manufactured, the vapor-phase growth apparatus has been changed from a batch type one which is capable of processing a plurality of substrates at one time to a single wafer type one which processes only one substrate at one time.

However, when a substrate support made of graphite having a large thermal capacity is used with a single wafer type growth apparatus, a long time is required to radiate the substrate support with radiant light from infrared lamps to heat the substrate support to a temperature of 1000 °C or more, so that a time required for the entire heat treatment step becomes longer, thus presenting the limit of the processing capability of the single wafer type growth apparatus.

To solve this problem, an annular supporting means for supporting the outer periphery of a silicon single crystal substrate has been proposed. Since this annular substrate support has a small volume, it is possible to largely reduce a time to heat the annular substrate support to a required temperature.

However, when a silicon single crystal substrate which is held with an annular substrate support made of graphite is heated to a temperature of 1000 °C or more, the slip dislocation may occur. The slip dislocation is more susceptible to occur as the diameter of the silicon single crystal substrate is larger.

Investigation on the higher susceptibility of slip dislocation due to the use of an annular substrate support made of graphite has revealed that in an outer peripheral portion a silicon single crystal substrate which is in contact with the annular substrate support, energy of radiant light is used to heat the substrate support, whereas in an inner peripheral portion of the silicon single crystal substrate which is not in contact with the annular substrate support, the radiant light directly heats the silicon single crystal substrate so that the temperature rises faster in the inner peripheral portion than the outer peripheral portion, thereby exhibiting a large temperature difference between the outer peripheral portion and the inner peripheral portion of the silicon single crystal substrate to generate a thermal stress.

To overcome this defect, quartz glass may be used as the material of the substrate support in place of graphite. Although the quartz glass can prevent the occurrence of the temperature difference by shielding the radiant light, the quartz glass has a thermal conductivity of 10 W/m·K ( watt/meter · kelvin) or less, considerably smaller than that of graphite equal to 45W/m · K, so that a substrate support made of quartz glass has poor effects in heating the outer peripheral portion of a silicon single crystal substrate at a uniform temperature. Consequently, the substrate support made of quartz glass cannot sufficiently prevent the generation of slip dislocation.

The present invention has been made in view of the problems inherent to the prior art mentioned above, and it is an object of the present invention to provide a heating apparatus which is capable of heating a silicon single crystal substrate to a desired temperature in a short time, capable of suppressing the generation of defects such as slip dislocation typically encountered in a semiconductor single crystal substrate and a semiconductor crystal thin film manufactured from the semiconductor single crystal substrate, and particularly useful in a process associated with the heating of future semiconductor single crystal substrates expected to have increasingly larger diameters.

To achieve the above object, the present invention provides a heating apparatus for heating a semiconductor single crystal substrate, which comprises; a transparent vessel having a heated region in which a semiconductor single crystal substrate is placed, a radiant heat source arranged outside the transparent vessel for emitting radiant light to the heated region of the transparent vessel, and a substrate support positioned between the radiant heat source and the semiconductor single crystal substrate for supporting the semiconductor single crystal substrate, wherein the substrate support is made of a material which transmits the radiant light emitted from the radiant heat source and has a higher heat conductivity than graphite.

As a preferred material which transmits radiant light, silicon carbide is used. Specifically, a preferred material for the substrate support is silicon carbide. In particular, the substrate support is preferably made of silicon carbide containing free silicon and free carbon in the proportion of 2 wt% or less in all, and is more preferably made of silicon carbide containing them in the proportion of 1 wt% or less in all.

As a material for the substrate support, it goes without saying that silicon carbide SiC containing a total amount of free silicon Si and free carbon C equal to 0 wt%, i.e., ideally pure silicon carbide SiC is most preferably used. With the proportion of free silicon Si and free carbon C exceeding 2 wt% in all, the transmissivity of radiant light abruptly begins to be degraded, so that the effect of the present invention cannot be sufficiently produced.

Although the substrate support is not limited to any particular shape, an annular shape is preferable. In addition, a disk-shape substrate support may also be used. It is also possible to form the substrate support in a conical shape, a trapezoidal shape, or the like depending on the shape and the number of semiconductor single crystal substrates to be heated.

As described above, the heating apparatus of the present invention is used to perform a heat treatment for a semiconductor single crystal substrate. In particular, the heating apparatus is preferably used to perform a heat treatment for adjusting the resistivity of a silicon semiconductor single crystal when a nitrogen gas is introduced; an oxidizing heat treatment for a silicon semiconductor single crystal when an oxygen gas is introduced; a surface modification heat treatment for a silicon semiconductor single crystal when a hydrogen gas is introduced; and processing for vapor-phase growing a silicon single crystal thin film when a gas including a silicon raw material is introduced.

The above and other objects, features and advantages of the present invention will become apparent from the following detailed description when read in conjunction with the accompanying drawings.
FIG. 1 is a schematic cross-sectional explanatory view showing an embodiment of a heating apparatus according to the present invention;
FIG. 2 is a schematic cross-sectional explanatory view showing another embodiment of the heating apparatus according to the present invention;
FIG. 3 is a graph showing an X-ray diffraction pattern of a substrate support used in Example 1;
FIG. 4 is a graph showing Raman scattering spectrum of the substrate support used in Example 1;
FIG. 5 is a graph showing light absorption spectrum of the substrate support used in Example 1;
FIG. 6 is a graph showing changes in temperature with the lapse of time in a central portion and in an outer peripheral portion of a silicon single crystal substrate mounted on substrate supports made of silicon carbide and graphite, respectively; and
FIG. 7 is a graph representing the relationship between the wavelength of light emitted by infrared lamps and relative intensity.

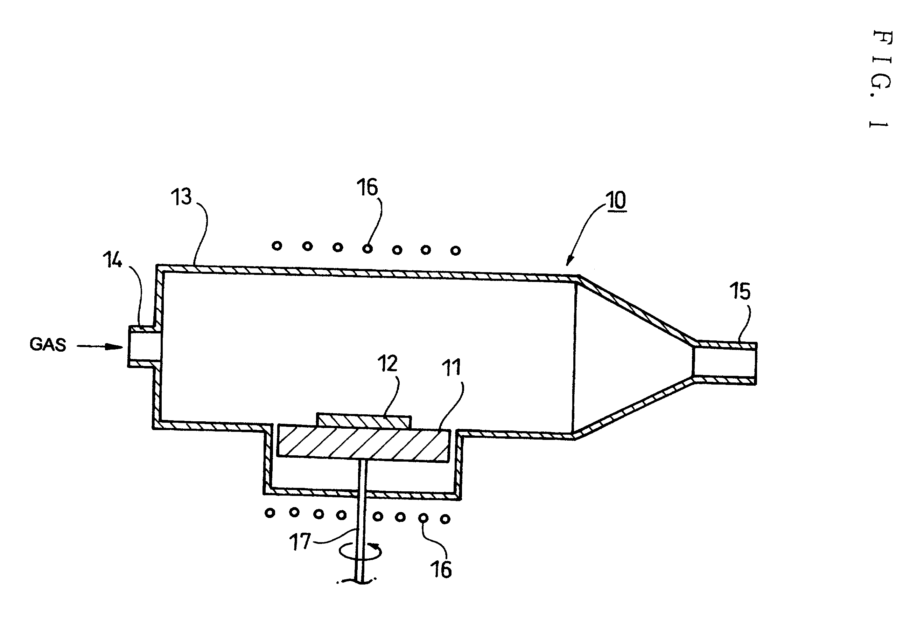

A heating apparatus according to one embodiment of the present invention will hereinafter be described with reference to FIG. 1.

FIG. 1 is a schematic cross-sectional explanatory view showing one embodiment of a heating apparatus 10 according to the present invention. The heating apparatus 10 is used to heat a semiconductor crystal substrate, for example, a silicon single crystal substrate 12. The heating apparatus 10 comprises a radiant heat source, for example, radiant heating lamps 16, for example, infrared lamps or the like, arranged outside a transparent vessel 13 made of transparent quartz glass, so that the radiant heat source radially heats the inside of the transparent vessel 13 through its transparent wall. A silicon single crystal substrate 12 is mounted on a substrate support 11 in a heated region within the transparent vessel 13.

Referring further to FIG. 1, reference numeral 14 denotes a gas introducing port which is arranged on a gas introducing side of the transparent vessel 13; and reference numeral 15 an exhaust port which is arranged on a gas exhausting side of the transparent vessel 13. A rotating shaft 17 is arranged on a lower surface of the substrate support 11 such that the substrate support 11 is rotated by the rotating shaft 17.

The above-mentioned heating apparatus 10 may be used for a heat treatment for adjusting the resistivity of a silicon semiconductor single crystal when a nitrogen gas is introduced into the transparent vessel 13 from the gas introducing port 14 while the silicon semiconductor single crystal is heated; for an oxidizing heat treatment when an oxygen gas or the like is introduced; and for a heat treatment for surface modification when a hydrogen gas is introduced. In addition, when a reactive gas including silicon is introduced into the transparent vessel 13, a single crystal thin film can be grown on the surface of the silicon semiconductor single crystal.

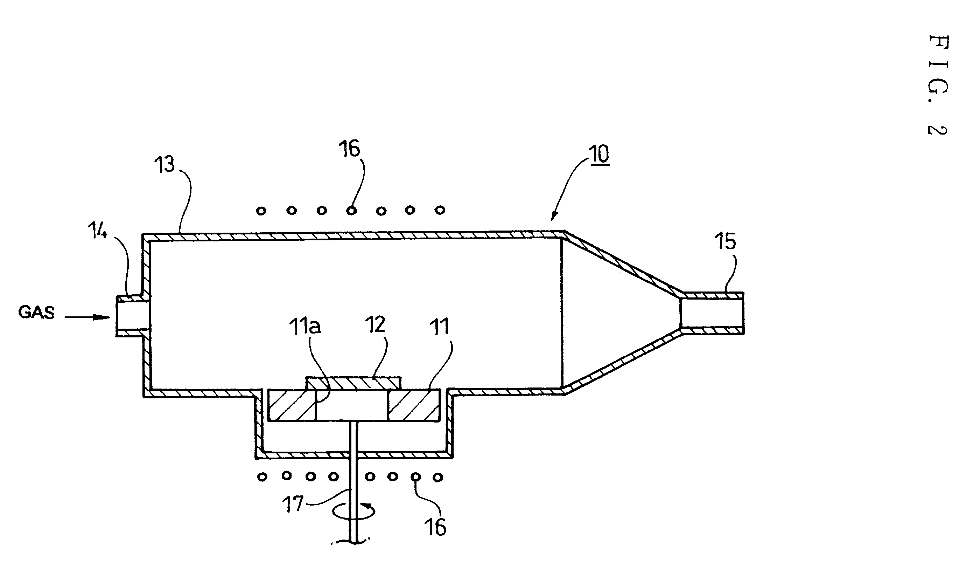

While an example of a plate-like substrate support 11 is illustrated in the embodiment shown in FIG. 1, an annular substrate support 11 formed with a hollow portion 11a at the center thereof may also be used as shown in FIG. 2.

As a material suitable for the substrate support 11, a material which transmits radiant light emitted from the radiant heat source 16 may be used. Such a material transmitting the radiant light is preferably silicon carbide SiC, and silicon carbide SiC containing free silicon Si and free carbon C in the proportion of 2 wt% or less in all is particularly preferable, and silicon carbide SiC containing them in the proportion of 1 wt% or less is further preferable.

As a material for the substrate support 11, it goes without saying that silicon carbide SiC containing a total amount of free silicon Si and free carbon C equal to 0 wt%, i.e., ideally pure silicon carbide SiC is most preferably used. With the proportion of free silicon Si and free carbon C exceeding 2 wt% in all, the transmissivity of radiant light abruptly begins to be degraded, so that the effect of the present invention cannot be sufficiently produced.

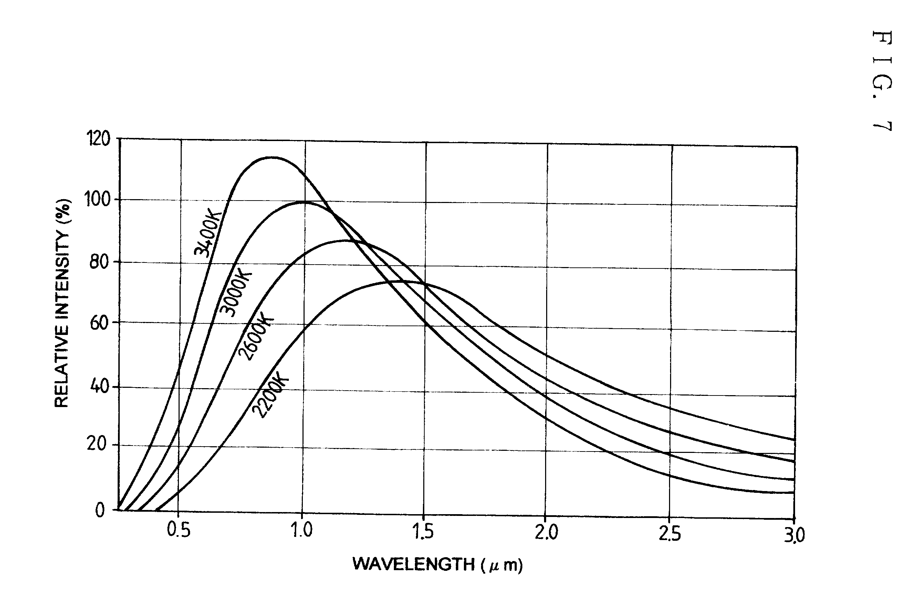

While conventionally used silicon carbide is black and opaque even in a state of a simple substance, highly pure silicon carbide formed by a vapor-phase thermal decomposition method and having a stoichiometric composition is originally transparent. Such silicon carbide is light yellow when in a thickness of approximately 1 mm, and has a property of transmitting substantially all radiant light emitted from infrared lamps, frequently used for radiant heating, i.e., light mainly composed of wavelengths near 1 *µ*m (FIG. 7).

Also, since silicon carbide has a thermal conductivity of 65 W/m · K which is higher than that of graphite, it can maintain a uniform temperature even in an outer peripheral portion of a substrate which is in contact with the substrate support. It should be noted that silicon carbide having a stoichiometric composition refers to silicon carbide composed of carbon and silicon in the same composition as the chemical formula, and does not lose the high heat conductive property inherent to silicon carbide.

Next, how the heating apparatus of the present invention is used will be specifically described with reference to several Examples.

### Example 1

In Example 1, the heating apparatus 10 having the shape shown in FIG. 2 was used. The substrate support 11 for the heating apparatus 10 is made of silicon carbide which is produced by a vapor-phase thermal decomposition method and in an annular shape having an outer diameter of 310 mm, an inner diameter of 290 mm and a thickness of 1 mm.

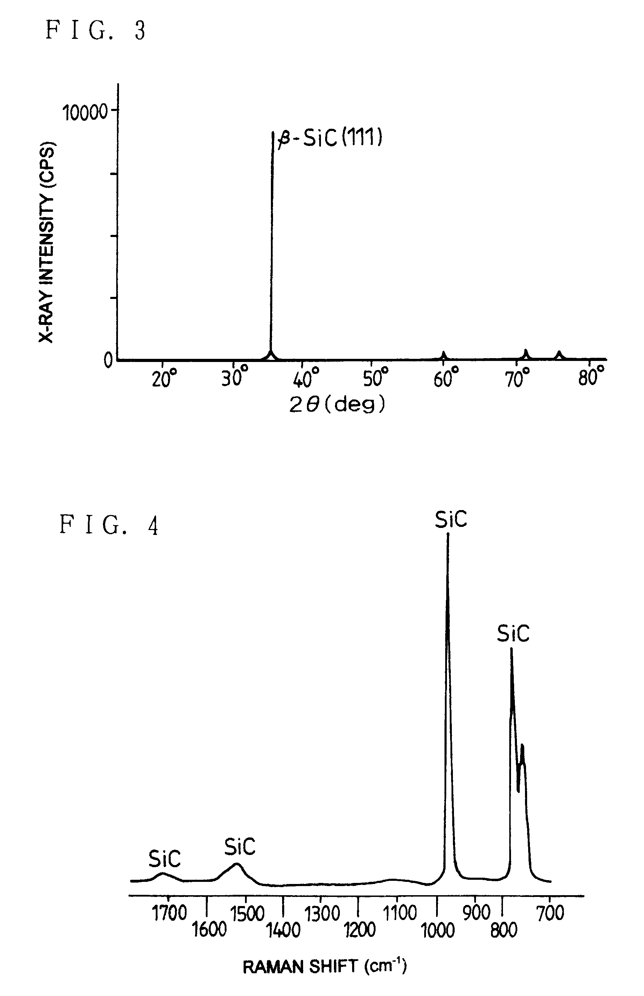

The substrate support 11 is translucent and light yellow. It was confirmed that no free silicon was mixed in the substrate support 11 from the fact that no diffraction peak other than that of silicon carbide was recognized in an X-ray diffraction pattern (FIG. 3). It was also confirmed that no free carbon was mixed from the fact that no Raman scattering light peak other than that of silicon carbide was observed in Raman scattering spectrum(FIG. 4).

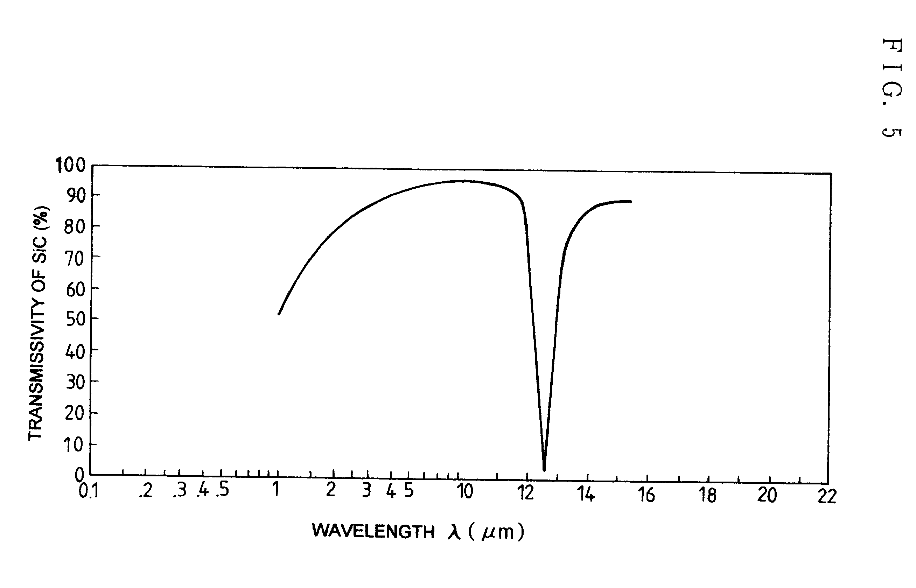

The light absorption spectrum of the substrate support 11 is shown in FIG. 5. It was also confirmed that the substrate support 11 had an effect of transmitting radiant light emitted from the infrared lamps 16 from the fact that a peak wavelength of light emitted by the infrared lamps 16 was centered at 1.5 *µ*m or less as shown in FIG. 7, whereas the silicon carbide exhibited a transmittance of 50% or so at approximately 1.5 *µ*m or less as shown in FIG. 5. On the other hand, graphite which has been used for the conventional substrate support exhibits a transmittance of 0% against light having a peak wavelength of approximately 1.5 *µ*m.

A 300-mm-diameter and p-type silicon single crystal substrate 12 having a (100)-oriented main surface was introduced into the transparent vessel 13 of the heating apparatus 10 shown in FIG. 2, and mounted on the substrate support 11. Once the silicon single crystal substrate 12 was mounted on the substrate support 11, it was rotated about the rotating shaft 17 until a heat treatment was completed.

The silicon single crystal substrate 12 with thermo-couples attached at the center and outer periphery thereof was mounted on the substrate support 11 made of the silicon carbide. Then, the infrared lamps 16 were lighted to heat the silicon single crystal substrate 12 to 1000 °C in two minutes, while nitrogen gas was introduced into the transparent vessel 13 from the gas introducing port, and then the silicon single crystal substrate 12 was maintained in this state for one hour. Then, the infrared lamps were put out to cool the silicon single crystal substrate 12 to room temperature.

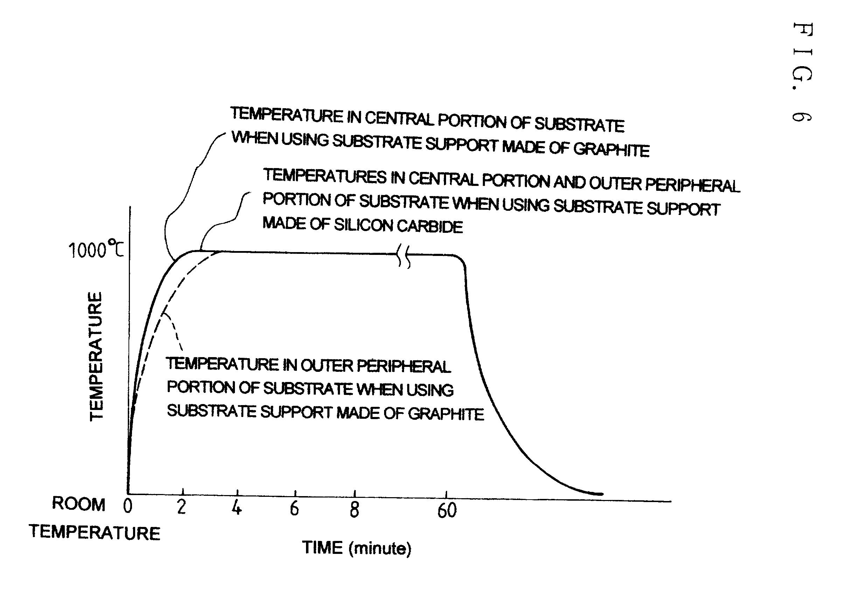

Temperatures obtained from the thermo-couples at this time are indicated by a solid line in FIG. 6. The thermo-couple attached to the outer periphery of the silicon single crystal substrate 12, which was positioned on the substrate support 11, and the thermo-couple attached to the center of the silicon single crystal substrate 12, which was positioned in the hollow portion 11a of the substrate support 11, could directly receive radiations from the infrared lamps 16 arranged above and below the substrate support 11.

For comparison, a heating apparatus having the same configuration as the heating apparatus 10 shown in FIG. 2, except that a substrate support of the same shape made of graphite was employed, was used to heat a similar silicon single crystal substrate in a similar manner. Temperatures obtained from thermo-couples are indicated by a broken line in FIG. 6.

Since silicon carbide transmits 50% or so of radiant light emitted from the infrared lamps 16, approximately 50% of the radiant light which is emitted from the infrared lamps 16 located below the transparent vessel 13 and reaches the substrate support 11 made of silicon carbide, directly reaches the silicon single crystal substrate 12. Although heating ability of light 50% transmitted is 0.84 times that of light 100% transmitted because the temperature of the silicon single crystal substrate 12 is proportional to supplied light energy to the power of 1/4, substantial deviation in temperature is not recognized during the temperature rise between the center and the outer periphery of the silicon single crystal substrate 12, as indicated by the solid line in FIG. 6.

With the substrate support made of graphite, on the other hand, the rate of temperature rise around the outer periphery of the silicon single crystal substrate 12 is lower than the rate of temperature rise at the center of the silicon single crystal substrate 12. It is apparent from this observation that the substrate support made of graphite once absorbs radiant light and then transfers heat to the silicon single crystal substrate 12 through conduction of heat.

In this event, while slip dislocation was observed in the silicon single crystal substrate 12 at the outer peripheral end and slighty inner side thereof which is heated using the substrate support made of graphite, any slip dislocation was not observed in the silicon single crystal substrate 12 heated using the substrate support made of silicon carbide of the present invention. The confirmation of slip was made by visual inspection and by an X-ray topography.

### Example 2

A 300-mm-diameter and p-type silicon single crystal substrate 12 having a (100)-oriented main surface was introduced into the heating apparatus 10 used in Example 1, and mounted on the substrate support 11.

After the silicon single crystal substrate 12 was heated to 1000 °C in two minutes by lighting the infrared lamps 16, the silicon single crystal substrate 12 was held at this temperature in a nitrogen gas, oxygen gas, or hydrogen gas atmosphere for one hour, and then the infrared lamps 16 were put out to cool the silicon single crystal substrate 12 to room temperature. When the silicon single crystal substrate 12 was observed after removing it from the heating apparatus 10, any slip dislocation was not observed in any of the heating atmospheres including the nitrogen gas, the oxygen gas and the hydrogen gas.

### Example 3

A 300-mm-diameter and p-type silicon single crystal substrate 12 having a (100)-oriented main surface was introduced into the heating apparatus 10 used in Example 1, and mounted on the substrate support 11.

The infrared lamps 16 were lighted to heat silicon single crystal substrate 12 to a temperature in a range of 800°C to 1000 °C in 30 seconds while a hydrogen gas was introduced into the reactor vessel 13 from the gas introducing port at a flow rate of 100 liter per minute. Subsequently, the silicon single crystal substrate 12 was maintained at the raised temperature for one minute while trichlorosilane was introduced into the reactor vessel 13 at a flow rate of 13 grams per second, and then the infrared lamps 16 were put out to cool the silicon single crystal substrate 12 to room temperature. When the silicon single crystal substrate 12 having a silicon single crystal thin film formed thereon approximately 1 *µ*m thick was observed, any slip dislocation was not observed in spite that the silicon single crystal substrate 12 had been heated in a short time. The conventional apparatus using a substrate support made of graphite takes approximately 2 minutes in heating a silicon single crystal substrate to 800 °C to 1000 °C in order to suppress the generation of slip dislocation.

As described above, the use of the heating apparatus according to the present invention allows radiant light emitted from the radiant heat source to reach a semiconductor single crystal substrate with transmitting the substrate support to substantially uniformly heat the entire semiconductor single crystal substrate including both inner peripheral portion and outer peripheral portion. In addition, a temperature difference unintentionally formed in the semiconductor single crystal substrate in contact with the substrate support can be eliminated by a high heat conductivity of silicon carbide.

As is appreciated, the heating apparatus according to the present invention utilizes infrared light emitted from radiant heating lamps such as infrared lamps or the like for heating a semiconductor single crystal substrate. While the foregoing Examples have been described principally about a silicon semiconductor single crystal, it is apparent that the present invention is also useful in heating, with radiant light, semiconductor polycrystal substrates, compound semiconductor such as gallium arsenide and so on.

As described above, according to the heating apparatus of the present invention, a large diameter semiconductor single crystal substrate can be rapidly heated using radiant light without generating slip dislocation during the heating, and hence high quality semiconductor crystal can be advantageously produced with a high processing capability.

Obviously, various minor changes and modifications of the present invention are possible in the light of the above teaching. It is therefore to be understood that within the scope of appended claims the invention mav be practiced otherwise than as specifically described.

## Claims

1. A heating apparatus for heating a semiconductor single crystal substrate comprising:
a transparent vessel having a heated region in which a semiconductor single crystal substrate is placed;
a radiant heat source arranged outside said transparent vessel for emitting radiant light to said heated region of said transparent vessel; and
a substrate support positioned between said radiant heat source and said semiconductor single crystal substrate for supporting said semiconductor single crystal substrate, said substrate support being made of a material which transmits the radiant light emitted from said radiant heat source and has a higher heat conductivity than graphite.

2. A heating apparatus according to claim 1, wherein said substrate support is made of silicon carbide containing free silicon and free carbon in the proportion of 2 wt% or less in all.

3. A heating apparatus according to claim 1 or 2, wherein said substrate support is annular.

4. A heating apparatus according to any one of claims 1 - 3, wherein said heating apparatus is used for performing a heat treatment for adjusting the resistivity of a silicon semiconductor single crystal when a nitrogen gas is introduced into said transparent vessel.

5. A heating apparatus according to any one of claims 1 - 3, wherein said heating apparatus is used for performing an oxidizing heat treatment for a silicon semiconductor single crystal when an oxygen gas is introduced into said transparent vessel.

6. A heating apparatus according to any one of claims 1 - 3, wherein said heating apparatus is used for performing a surface modification heat treatment for a silicon semiconductor single crystal when a hydrogen gas is introduced into said transparent vessel.

7. A heating apparatus according to any one of claims 1 - 3, wherein said heating apparatus is used for vapor-phase growing a silicon single crystal thin film when a gas including a silicon raw material is introduced into said transparent vessel.
